Europäisches Patentamt

**European Patent Office**

**Office européen des brevets**

(11) Numéro de publication: **0 401 070**
**A1**

(12) **DEMANDE DE BREVET EUROPEEN**

(21) Numéro de dépôt: **90401258.0**

(22) Date de dépôt: **11.05.90**

(51) Int. Cl.⁵: **H01L 29/10, H01L 29/796, H01L 27/148**

(30) Priorité: **30.05.89 FR 8907085**

(43) Date de publication de la demande:
**05.12.90 Bulletin 90/49**

(84) Etats contractants désignés:
**DE FR GB NL**

(71) Demandeur: **THOMSON COMPOSANTS
MILITAIRES ET SPATIAUX
50, rue J.P. Timbaud
F-92400 Courbevoie(FR)**

(72) Inventeur: **Roy, François
Thomson-CSF, SPCI-Cédex 67
F-92045 Paris La Défense(FR)**
Inventeur: **Thenoz, Yves
Thomson-CSF, SPCI-Cédex 67
F-92045 Paris La Défense(FR)**
Inventeur: **Tassin, Catherine
Thomson-CSF, SPCI-Cédex 67
F-92045 Paris La Défense(FR)**

(74) Mandataire: **Guérin, Michel et al
THOMSON-CSF SCPI
F-92045 PARIS LA DEFENSE CEDEX 67(FR)**

(54) **Dispositif à transfert de charge à polarisation de substrat par contact redresseur.**

(57) L'invention concerne les dispositifs à transfert de charges, et tout spécialement les matrices et les barrettes photosensibles. Ces dispositifs sont réalisés sur un substrat semiconducteur portant des grilles servant à effectuer les transferts de charge en fonction des séquences de potentiels qu'elles reçoivent. Ces potentiels sont référencés par rapport à un potentiel de référence, par exemple la masse, et en général le substrat est relié à la masse par un contact ohmique métallisé en face arrière du substrat. Pour les matrices photosensibles sur substrat aminci, on utilise un contact ohmique en face avant, mais cela nécessite des opérations technologiques supplémentaires. Selon l'invention, on a constaté qu'on pouvait relier le substrat (10, 12) au potentiel de référence (M) non pas par un contact ohmique mais par un contact redresseur, par exemple par l'intermédiaire d'une jonction PN (30, 40, 12). Le substrat n'est plus à potentiel fixe, mais le fonctionnement n'est en général pas perturbé. De plus, certains défauts tels que les "points blancs" de matrices photosensibles sont éliminés.

FIG.3

# DISPOSITIF A TRANSFERT DE CHARGE A POLARISATION DE SUBSTRAT PAR CONTACT REDRESSEUR

L'invention concerne les dispositifs transfert de charge.

Ces dispositifs sont en général fabriqués sur un substrat de silicium, par exemple sur un substrat de silicium de type P + sur lequel on a fait croître une couche épitaxiale de même type moins dopée. Des grilles isolées par une couche isolante mince sont déposées sur la surface du substrat et sont commandées par des successions de potentiel propres à provoquer le transfert de charges dans le silicium au dessous des grilles, pour faire passer ces charges d'une grille à la suivante. Les charges tendent en effet à se déplacer entre des puits de potentiel créés sous les grilles; ces puits sont créés lorsqu'une différence de potentiel est appliquée entre la grille et le substrat.

Ces dispositifs sont beaucoup utilisés pour réaliser des capteurs photosensibles. Dans ce cas, les charges électriques sont produites par effet photoélectrique : elles sont créées par l'éclairement du silicium. Puis elles sont transférées en vue de leur utilisation grâce aux applications de séquences appropriées de potentiels sur les grilles. Les transferts de charge se produisent à l'intérieur du substrat près de la surface de celui-ci (ou parfois à la surface même du substrat).

Pour appliquer des différences de potentiel bien déterminées entre les différentes grilles et le substrat, alors que les grilles sont indépendantes les unes des autres mais que le substrat est commun à toutes les grilles, on porte le substrat à un potentiel de référence fixe, par exemple une masse générale du circuit dans lequel le dispositif à transfert de charges est incorporé, et on applique aux grilles des potentiels variables par rapport à ce potentiel de référence, les potentiels appliqués aux grilles étant fonction des effets à obtenir, en particulier des transferts de charge successifs à obtenir.

Pour porter le substrat à un potentiel de référence, l'habitude est de recouvrir la face arrière du substrat d'une métallisation conductrice, en constituant un contact ohmique entre le substrat et cette métallisation. La métallisation est portée à un potentiel de référence fixe. Si le substrat est de type P + recouvert d'une couche épitaxiale de type P sur sa face avant on obtient directement un contact ohmique par métallisation de la face arrière. Si le substrat était de type P relativement peu dopé, il serait nécessaire de surdoper la face arrière de manière à la rendre P + pour avoir un contact ohmique.

Cette construction a pratiquement toujours été utilisée jusqu'à maintenant de manière satisfaisante.

Toutefois, l'avance technologique dans le domaine des capteurs photosensibles notamment a fait apparaître le besoin de travailler sur des substrats extrêmement minces (en vue d'une possibilité d'éclairement par la face arrière), et il est apparu des défauts à l'usage, du fait de la métallisation de face arrière.

On a donc proposé, pour ce type d'application, de porter le substrat à un potentiel de référence fixe à partir d'un contact ohmique réalisé sur la face avant du substrat. Dans ce cas, le contact ohmique est fait par un dopage de type P + dans une zone de contact du substrat, cette zone étant recouverte d'une métallisation.

Mais cette construction présente l'inconvénient de nécessiter des étapes de masquage et diffusion supplémentaires (en pratique deux masquages supplémentaires, un pour le dopage général de type P + et un pour la prise de contact spécifique).

La présente invention a pour but de proposer une structure de dispositif photosensible qui non seulement ne présente pas les inconvénients de la technique antérieure mais qui de plus présente dans certains cas des avantages tout-à-fait appréciables.

On propose selon l'invention de faire fonctionner le dispositif en reliant le substrat à un potentiel de référence par l'intermédiaire d'un contact redresseur au lieu de le relier à ce potentiel de référence par l'intermédiaire d'un contact ohmique.

Non seulement l'invention permet alors de se passer d'un contact de face arrière sans introduire pour autant des étapes de masquage et dopage supplémentaires que nécessite un contact ohmique sur la face avant, mais, d'une manière inattendue, on a constaté que l'on obtient par ce moyen une amélioration très importante sur le fonctionnement de certains dispositifs à transfert de charges. C'est le cas en particulier pour des barrettes ou matrices photosensibles dans lesquelles on a constaté que l'utilisation d'un contact redresseur au lieu d'un contact ohmique amenait la suppression de défauts du type "points blancs"; ces défauts sont des points photosensibles qui ont un courant d'obscurité plus élevé que leurs voisins, pour des raisons mal expliquées. L'utilisation de l'invention provoque la disparition de beaucoup de ces points blancs. Le rétablissement d'un contact ohmique provoque leur réapparition.

Pour le reste, on a constaté que, en tous cas dans les dispositifs à transferts de charge les plus classiques, le fonctionnement normal de ces dispositifs n'était pas perturbé. Les perturbations qui pourraient exister sont des influences du second ordre, par exemple sur la linéarité de dispositifs qui seraient assez sensibles à l'influence des variations de tension de mode commun; c'est le cas lorsque la lecture se fait par un ampli de tension; ce n'est pas le cas lorsque c'est une lecture en courant. La présente demande de brevet ne prétend donc pas que l'amélioration apportée soit universelle, mais elle permet une simplification technologique importante dans certains cas et une amélioration par suppression de défauts dans certains cas.

De préférence le contact redresseur sera placé en face avant: en effet, d'une part cela est possible sans compliquer le processus de fabrication normal du dispositif, et d'autre part cela est très avantageux comme on l'a dit dans le cas de capteurs photosensibles à substrat aminci.

Ce contact redresseur sera réalisé de préférence par un jonction NP dont un côté est constitué par le substrat dans lequel est formé le dispositif (dans le cas de dispositifs formés dans une couche épitaxiale de type P, la jonction NP peut être faite par une région N+ diffusée ou implantée dans le substrat ou dans une réion dopée du substrat).

D'autres caractéristiques et avantages de l'invention apparaîtront à la lecture de la description détaillée qui suit et qui est faite en référence aux dessins annexés dans lesquels :

- la figure 1 représente en coupe la structure classique d'un dispositif à transfert de charge;
- la figure 2 représente une variante de réalisation qu'on a pu proposer dans le cas de matrices photosensibles amincies;
- la figure 3 représente une structure selon l'invention.

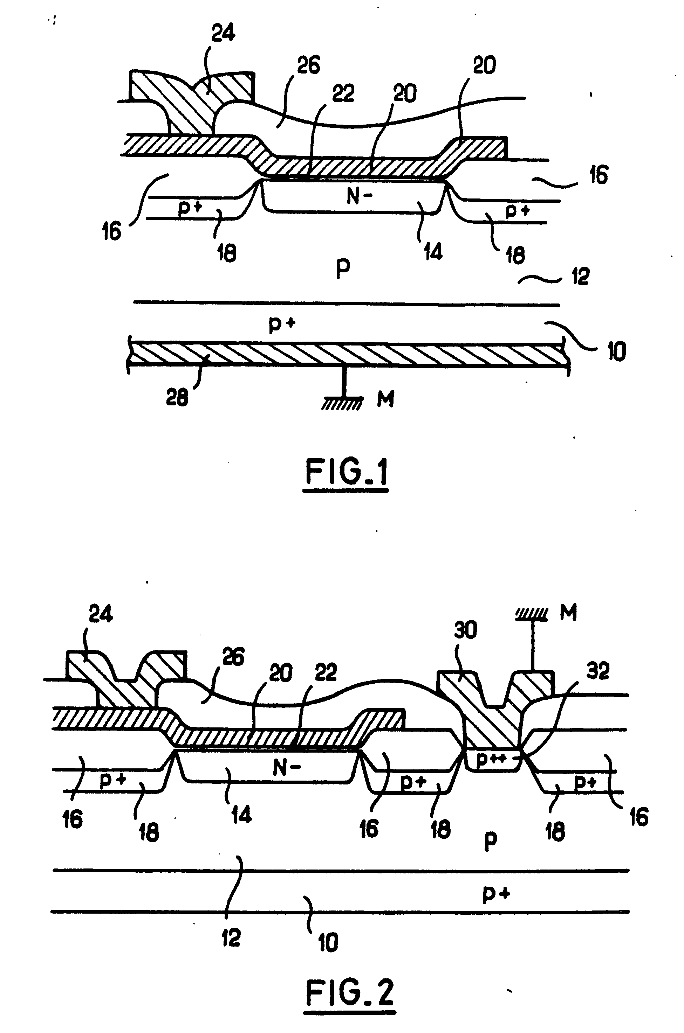

Sur la figure 1 (art antérieur), on reconnaît la structure habituelle d'un dispositif à transfert de charges, photosensible ou non.

Il comprend un substrat 10 d'un premier type de conductivité, par exemple de type P fortement dopé qu'on désignera par P+. Sur ce substrat on a fait croître une couche épitaxiale 12 de même type, moins dopée (type P). Sur le dessin, les échelles d'épaisseur ne sont pas respectées, le substrat 10 de type P+ étant en réalité beaucoup plus épais que la couche épitaxiale 12.

Les différentes régions de transfert de charges sont des régions superficielles 14 de la couche épitaxiale, légèrement dopées avec une impureté de type opposé (N-) pour que le transfert de charges se fasse à l'intérieur du substrat (transfert en volume) plutôt qu'à la surface même de celui-ci (transfert en surface). Ces régions 14 sont séparées les unes des autres par des zones d'oxyde de silicium épais 16 sous lesquelles s'étendent des couches anti-inversion 18 de type P+.

Les grilles classiques servant à commander les transferts de charge sont des couches de silicium polycristallin 20 déposées au dessus des régions 14 et isolées d'elles par une couche isolante mince 22. Les potentiels appropriés sont amenés à ces couches 20 par des conducteurs métalliques 24, de préférence en aluminium, venant contacter ponctuellement les différentes zones de silicium polycristallin 20 à travers des ouvertures faites dans une couche isolante 26 recouvrant le substrat et les grilles.

C'est par le choix des séquences de potentiel appliqués entre les grilles et le substrat dans lequel se déplacent les charges que l'on fait fonctionner le dispositif. C'est pourquoi le substrat est porté à un potentiel de référence, par exemple une masse électrique M. Pour cela, comme on le voit sur la figure 1, l'arrière du substrat de type P+ est recouvert d'une couche conductrice 28 reliée au potentiel de référence. Le contact est ohmique, du fait du dopage important de la surface arrière du substrat (par exemple le dopage est supérieur à $10^{18}$ atomes d'impuretés par centimètres cube alors que le substrat n'est dopé qu'avec $10^{15}$ atomes par centimètre cube en face avant.

Dans une autre réalisation, représentée à la figure 2, et spécialement envisagée pour les matrices photosensibles amincies, on a remplacé le contact ohmique de face arrière par un contact ohmique de face avant pour relier le substrat à un potentiel de référence.

Dans cette réalisation, les éléments de la structure sont les mêmes qu'à la figure 1 et portent les mêmes références, mais une zone 32 de contact d'une électrode métallique 30 avec le substrat a été réservée sur la face avant du substrat. Cette zone 32 est séparée des zones voisines par des régions d'oxyde épais avec couche P+ sous-jacente, tout-à-fait semblables aux régions 16, 18 déjà mentionnées. Cette zone 32 est dopée de type P+ ou P++, suffisamment pour permettre la réalisation d'un contact ohmique. Une portion de couche métallique déposée et gravée en même temps que la couche 24 constitue l'électrode 30 en contact ohmique avec la zone 32. Cette électrode 30 est portée à un potentiel de référence fixe (masse M).

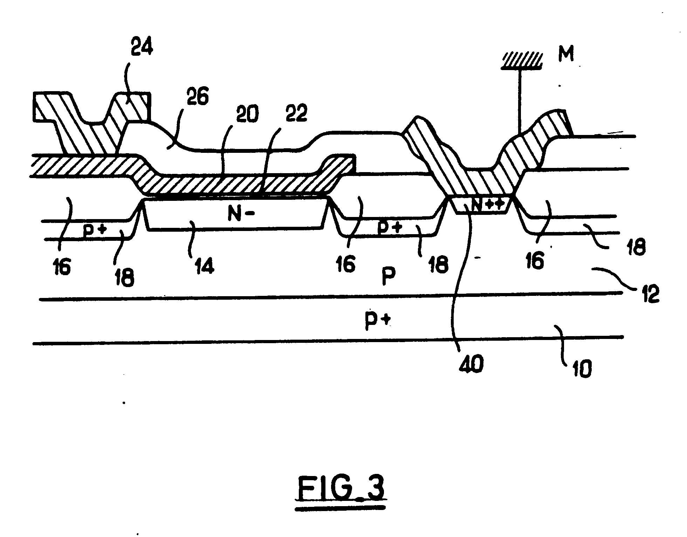

Selon l'invention, on propose une structure de dispositif photosensible telle que celle qui est représentée à la figure 3 mais dans laquelle le contact entre le substrat et le le potentiel de référence est un contact redresseur au lieu d'être un contact ohmique. Sur la figure 3, les éléments correspondants à ceux des autres figures sont désignés par les mêmes références.

Dans l'exemple de la figure 3, le contact est pris sur la face avant, ce qui est particulièrement avantageux et facile à réaliser.

Dans cet exemple, le contact redresseur est en effet réalisé par une jonction NP intercalée entre le substrat et une électrode reliée à un potentiel de référence.

C'est par rapport à ce potentiel de référence que seront définis les différents potentiels de grille à appliquer aux grilles du dispositif à transfert de charge. Comme le contact entre substrat et potentiel de référence est redresseur, le potentiel du substrat ne sera pas fixe. On a constaté selon l'invention que non seulement cela ne perturbait pas le fonctionnement normal de la plupart des dispositifs, notamment les capteurs photosensibles, mais que de plus cela supprimait des défauts du type "points blancs" constatés avec une polarisation fixe du substrat et supprimés avec une polarisation par contact redresseur.

Le substrat n'est donc relié au potentiel de référence (masse) que par l'intermédiaire d'une jonction NP en série.

Cette jonction est réalisée par diffusion ou implantation superficielle d'une région 40 de type N + + dans le substrat de type P. Il faut signaler que la plupart des dispositifs à transfert de charges nécessitent de toutes façons des implantations ou diffusions de telles régions N + + (pour faire des diodes et transistors, notamment en entrée et sortie du dispositif) et qu'on ne rajoute donc pas d'étape technologique en prévoyant cette région de dopage N + +.

Une électrode de contact de face avant 30, semblable à celle de la figure 2 et réalisée de la même manière, est déposée sur la région 40 de type N + +, et elle est reliée au potentiel de référence. Le substrat n'est pas relié à ce potentiel de référence d'une autre manière que par la jonction NP ainsi réalisée. Bien entendu, si le substrat était de type N, la région 40 serait de type P. Dans une variante de réalisation, avant de doper de type N + + la région 40, on peut surdoper localement le substrat dans cette région avec une impureté de type P + ; cela a l'avantage d'augmenter la capacité de jonction du contact redresseur, ce qui est préférable. Dans ce cas, la jonction NP comprend d'un côté une région surdopée du substrat, de même type que le substrat, et de l'autre côté la région dopée N + + du type opposé au substrat, recouverte de l'électrode reliée au potentiel de référence. Le surdopage P + consiste par exemple à implanter un taux d'impuretés 10 ou 100 fois plus fort que le taux d'impuretés initial de la couche épitaxiale, tout en restant cependant 10 ou 100 fois plus faible que le taux d'impuretés N + + qui sera ensuite implanté, afin qu'il se crée bien une jonction N + P + sous l'électrode 30.

## Revendications

1. Dispositif à transfert de charges comprenant un substrat (10, 12) semiconducteur et des grilles (20) de transfert de charges recevant des signaux de commande référencés par rapport à un potentiel de référence (M), caractérisé en ce que la liaison entre le substrat et le potentiel de référence est assurée à travers un contact redresseur (30, 40, 12)).

2. Dispositif à transfert de charges selon la revendication 1, caractérisé en ce que le contact redresseur est réalisé à l'aide d'une jonction semiconductrice NP.

3. Dispositif à transfert de charges selon l'une des revendications 1 et 2, caractérisé en ce que le contact redresseur est réalisé sur la face avant du substrat, par une diffusion localisée (40) d'une impureté du type opposé au substrat, recouverte d'une électrode reliée au potentiel de référence.

4. Dispositif selon l'une des revendications 1 et 2, caractérisé en ce que le contact redresseur est réalisé sur la face arrière du substrat.

5. Dispositif selon l'une des revendications précédentes, constituant un capteur photosensible.

6. Dispositif selon la revendication 5, caractérisé en ce qu'il est réalisé sur un substrat aminci susceptible d'être éclairé par l'arrière.

7. Dispositif selon l'une des revendications précédentes, caractérisé en ce que le contact redresseur est réalisé par une métallisation déposée sur une couche épitaxiale peu dopée du substrat.

8. Dispositif selon la revendication 7, caractérisé en ce que la couche épitaxiale peu dopée est une couche de même type que les couches dans lesquelles s'effectuent les transferts de charge sous les grilles du dispositif.

## FIG.1

## FIG.2

## FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 099 474 (GENERAL ELECTRIC CO.) * Page 3, ligne 36 - page 7, ligne 17; figures 1,2 * --- | 1,2,4 | H 01 L 29/10 H 01 L 29/796 H 01 L 27/148 |
| A | EP-A-0 098 191 (THOMSON CSF) ----- | | |

**DOMAINES TECHNIQUES RECHERCHES (Int. Cl.5)**

H 01 L

Le présent rapport a été établi pour toutes les revendications

| Lieu de la recherche | Date d'achèvement de la recherche | Examinateur |
|---|---|---|
| LA HAYE | 05-09-1990 | BAILLET B.J.R. |